# EUROPEAN PATENT SPECIFICATION

(11) **EP 3 958 657 B1**
(45) Date of publication and mention of the grant of the patent: **15.11.2023**
(21) Application number: 21275106.9
(22) Date of filing: 06.08.2021
(51) Int. Cl.: H05K 7/10

(54) **IMPROVED INSULATED SOCKET BODY AND TERMINALS FOR A LAND GRID ARRAY SOCKET ASSEMBLY**
VERBESSERTE ISOLIERTE BUCHSENKÖRPER UND ANSCHLÜSSE FÜR LAND-GRID-ARRAY-BUCHSENANORDNUNGEN
CORPS DE DOUILLE ISOLÉ AMÉLIORÉ ET BORNES POUR UN ENSEMBLE DOUILLE DE BOÎTIER MATRICIEL À BILLES

(30) Priority: 12.08.2020 US 202016991073
(43) Date of publication of application: 23.02.2022
(73) Proprietor: Tate, John O., Lincoln, RI 02865 (US)
(72) Inventor: Tate, John O., Lincoln, RI 02865 (US)
(74) Representative: Wilson Gunn

(56) References cited:
- US-A- 5 362 241
- US-A- 6 043 666
- US-A1- 2008 003 849
- US-A1- 2012 208 381
- US-B1- 8 373 430

## Description

### Cross Reference to Related Applications

This application is a continuation-in-part of, and claims benefit to, U.S. Application No. 16/791,952 filed February 14, 2020, entitled "IMPROVED INSULATED SOCKET BODY AND TERMINALS FOR A LAND GRID ARRAY SOCKET ASSEMBLY," which is related to and claims benefit of U.S. Provisional Application No. 62/807,085 filed February 18, 2019, entitled "IMPROVED INSULATED SOCKET BODY AND TERMINALS FOR A LAND GRID ARRAY SOCKET ASSEMBLY,".

### Background of the Disclosure

The present disclosure relates generally to electronic device connectors or sockets and more particularly to land grid array (LGA) sockets for connecting land grid array (LGA) chips to printed circuit boards (PCBs).

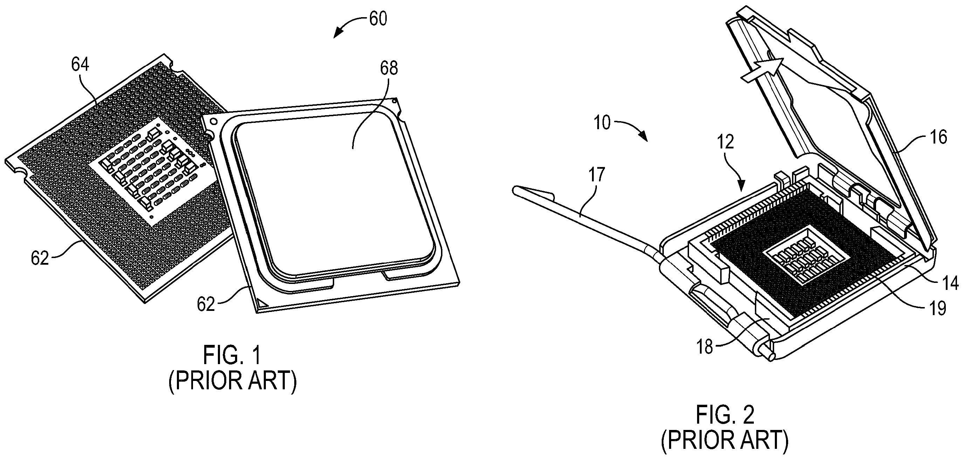

LGA connector assemblies or sockets are widely used in the connector industry for electrically connecting LGA chips to PCBs, particularly in personal computers. Referring to Fig. 1, many of the current PC processors are manufactured in an LGA chip package 60 which includes a circuit substrate 62 having a plurality of gold contact pads 64 arranged in an array. The chip (not shown) is mounted on the upper surface of the substrate 62 and enclosed in an integrated heat sink closure or cap 68.

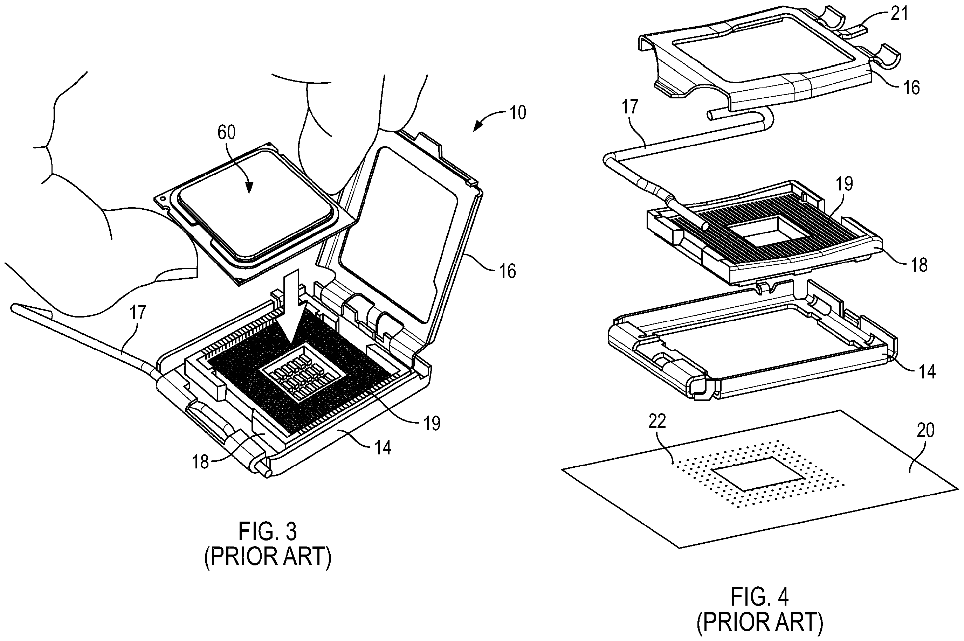

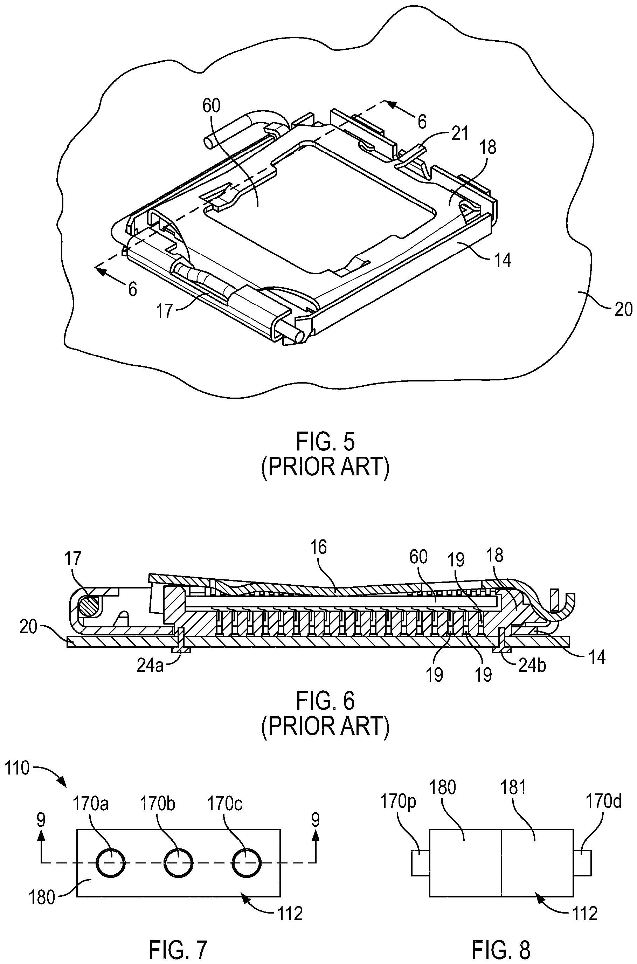

Referring to Figs. 2-6, a typical prior art LGA socket assembly or fixture 10 is illustrated. The LGA socket connector assembly 10, in general, comprises a hinged frame generally indicated at 12 having a lower mounting portion 14 and an upper load plate 16. Within the frame 12, for example in the lower mounting portion 14, is an insulated socket body 18 containing a plurality of electrical terminals 19 which extend through the socket body 18. The socket assembly 10 is mounted onto a PCB 20 (see Figs. 4 and 6) where the lower contact end of the terminals 19 engages a plurality of gold contact pads 22 arranged in an array on the PCB 20. The socket assembly 10 is retained in position on the PCB 20 with screws 24a, 24b extending through the PCB 20 and into the insulated socket body 18 (Fig. 6), or by other known means. Turning back to Fig. 3, the load plate 16 is hinged open to receive the LGA chip 60 which is seated into the insulated socket body 18. The LGA contact pads 64 on the lower surface of the LGA chip 60 engage the upper contact ends of the terminals 19 exposed on the upper surface of the socket body 18. The load plate 16 is hinged closed and retained with a locking bar 17 (Fig. 5) to maintain good electrical contact pressure between the LGA chip 60 and the terminals 19 of the socket body 18. In some embodiments, a spring tab 21 can be located on the load plate to increase the pressure between the LGA chip 60 and the terminals 19.

While fully functional for their intended purpose, the prior art terminals 19 have delicate contact ends which can be easily damaged by incorrect assembly or misalignment of the socket assembly 10 with the PCB 20 or incorrect insertion of the LGA chip 60 into the socket body 18. Thus, there is a perceived need in the industry for a more robust socket body and terminal design in which the terminals are not as easily damaged.

US2012/208381A1 discloses a twist pin which is used as an interconnect interface to conduct signals to and from an electronic component. The twist pin includes a bulge which establishes compressive contact force with a sidewall in which the twist pin resides, and the resulting force resists movement of the end of the twist pin away from the electronic component to assure good signal conductivity.

US8373430B1 discloses a low inductance probe comprising conductively coupled plungers, The plungers have coupling means which enable them to be slidably and non-rotatably engaged. A coil spring is attached to the plungers in a manner that prevents rotation of the spring's ends. The spring provides an axial plunger bias, and a torsional bias for conductive coupling between the plungers.

US6043666 discloses an electroconductive contact unit including an electroconductive coil member received in an axial bore with the axial ends of the coil member projecting from the axial bore so as to serve as contact pin sections, the contact pin sections are formed by closely wound segments of the coil member while the middle part of the coil member is formed as a compression coil spring section for biasing the contact pin sections.

### Summary of the Invention:

According to a first aspect of the present invention, there is provided an insulated socket body according to claim 1.

An object of the invention is an improved socket body and terminal configuration for use in both LGA production sockets, LGA test sockets, and other electronic component sockets. The assembly includes an insulated socket body comprising upper and lower insulated socket body portions which are received together in mated relation to define a socket body having a plurality of lumens extending therethrough. The assembly further includes a like plurality of monolithic spring terminals received within the lumens, wherein the spring terminals include upper and lower contact ends connected by a central cantilever spring. The central cantilever springs are received within central recess portions of the lumens and the upper and lower contact ends are received in respective upper and lower guide portions of the lumens and project outwardly from respective upper and lower surfaces of the upper and lower insulated socket body portions. The improved spring terminals provide biased spring compression in both directions of contact and further provides independent movement of the upper and lower contact ends within the socket body. In some embodiments, the instant spring terminal contacts can advantageously be unitary, monolithic, or made of a single piece of material. Alternatively, the instant spring terminals can be manufactured from a plurality of pieces of material in some embodiments. Further, in some embodiments, the spring terminals contact can be formed from a wire and can have a generally circular, triangular, square, rectangular, or other cross-sectional shapes.

According to one aspect of the present invention, there is provided an insulated socket body and terminal assembly comprising, an upper insulated socket body portion; a lower insulated socket body portion, wherein the upper and lower insulated socket body portions are received together in mated relation to define a socket body having at least one lumen extending therethrough; and at least one spring terminal received within the at least one lumen, the spring terminal including upper and lower contact ends connected by a central cantilever spring, wherein the central cantilever spring is received within a central recess portion of the lumen and the upper and lower contact ends are received in respective upper and lower guide portions of the lumen and project outwardly from respective upper and lower surfaces of the upper and lower insulated socket body portions, said central recess portion of the at least one lumen being configured to retain the cantilever spring of at least one spring terminal in a first uncompressed configuration and in a second compressed configuration, and wherein the upper and lower insulated socket body portions are at least partially eccentric with respect to each other, and wherein the upper and lower insulated socket body portions are eccentric with respect to each other at a mating plane between the upper and lower insulated socket portions such that there is an upper shoulder defined at a lower end of the upper insulated socket body portion and a lower shoulder defined at an upper end of the lower insulated socket body.

The upper and lower insulated socket body portions are eccentric with respect to a central axis of the at least one lumen. The central cantilever spring of the at least one spring terminal may be formed in the shape of a Z shape, double Z shape, S shape, or double V shape. The upper and lower contact ends of the at least one spring terminal may have a circular cross section. the central cantilever spring may have a rectangular cross section. The at least one spring terminal may have a circular cross section. The central cantilever spring includes at least one horizontally extending portion that is disposed against the upper and lower shoulders. The central cantilever spring may include a first Z-shaped spring and a second Z-shaped spring. The first Z-shaped spring and the second Z-shaped spring may be mirrored about a compression axis of the at least one spring terminal and an axis which is perpendicular to the compression axis. The at least one spring terminal may be monolithic. The assembly may further comprise a plurality of lumens and a plurality of spring terminals.

According to another aspect of the present invention, there is provided an electronic device fixture, the fixture comprising: a lower frame; an upper load plate hinged to the lower frame, an insulated socket body received in the lower frame, the insulated socket body comprising, an upper insulated socket body portion, and a lower insulated socket body portion, wherein the upper and lower insulated socket body portions are received together in mated relation and define a plurality of lumens extending therethrough; a plurality of spring terminals each respectively received within the plurality of lumens, the plurality of spring terminals each including upper and lower contact ends connected by a central cantilever spring, wherein the central cantilever spring of each spring terminal is received within a central recess portion of each respective lumen and the upper and lower contact ends of each spring terminal are received in respective upper and lower guide portions of each respective lumen and project outwardly from respective upper and lower surfaces of the upper and lower insulated socket body portions, said central recess portion of each respective lumen being configured to retain the respective cantilever spring of each respective spring terminal in a first uncompressed configuration and in a second compressed configuration, and wherein the upper and lower insulated socket body portions are eccentric with respect to each other at a mating plane between the upper and lower insulated socket portions such that there is an upper shoulder defined at a lower end of the upper insulated socket body portion and a lower shoulder defined at an upper end of the lower insulated socket body.

The upper and lower insulated socket body portions are eccentric with respect to a central axis of the at least one lumen. The central cantilever spring of each respective spring terminal may be formed in the shape of a double Z shape, S shape, or double V shape. The upper and lower contact ends of each respective spring terminal may have a circular cross section. The central cantilever spring of each respective spring terminal may have a rectangular cross section. Each respective spring terminal may have a circular cross section. The central cantilever spring includes at least one horizontally extending portion that is disposed against the upper and lower shoulders. The central cantilever spring may include a first Z-shaped spring and a second Z-shaped spring. The first Z-shaped spring and the second Z-shaped spring may be mirrored about a compression axis of the at least one spring terminal and an axis which is perpendicular to the compression axis. Each respective spring terminal may be monolithic.

According to a further aspect of the present invention, there is provided an insulated socket body and terminal assembly comprising, an upper insulated socket body portion; a lower insulated socket body portion, wherein the upper and lower insulated socket body portions are received together in mated relation to define a socket body having at least one lumen extending therethrough, and wherein the upper and lower insulated socket body portions are eccentric with respect to each other at a mating plane such that there is an upper stop shoulder defined at a lower end of the upper insulated socket body portion and a lower stop shoulder defined at an upper end of the lower insulated socket body; and at least one spring terminal received within the at least one lumen, the spring terminal including upper and lower contact ends connected by a central cantilever spring, wherein the central cantilever spring is received within a central recess portion of the lumen and the upper and lower contact ends are received in respective upper and lower guide portions of the lumen and project outwardly from respective upper and lower surfaces of the upper and lower insulated socket body portions, said central cantilever spring having opposing ends which respectively engage said upper and lower stop shoulders to provide respective fixed spring points for the upper and lower contact ends of said spring terminal.

A portion of the central cantilever spring extends transversely across said lumen. A portion of the central cantilever spring extends parallel to said mating plane.

Other objects, features and advantages of the invention shall become apparent as the description thereof proceeds when considered in connection with the accompanying illustrative drawings.

### Description of the Drawings:

In the drawings which illustrate the best mode presently contemplated for carrying out the present invention:
Fig. 1 illustrates top and bottom views of a prior art land grid array (LGA) chip package;
Figs. 2 and 3 illustrate a prior art LGA socket assembly;
Fig. 4 illustrates an exploded view of the prior art LGA socket assembly with a PCB and corresponding contact array;
Fig. 5 illustrates a perspective view of the socket assembly of Fig. 4;
Fig. 6 illustrates a cross-sectional view thereof taken along line 6-6 of Fig. 5;
Fig. 7 is a top view of an improved insulated socket body and spring terminal in accordance with a first example not covered by the claimed invention;
Fig. 8 is side view of the improved socket body and spring terminal of Fig. 7;
Fig. 9 is a cross sectional view of the improved socket body and spring terminal of Fig. 7 along line 9-9 of Fig. 7;
Fig. 10 is a perspective cross sectional view of the improved socket body and spring terminal of Fig. 7 along line 9-9 of Fig. 7;
Fig. 11 is a partial perspective view of a bottom socket body and two spring terminals disposed therein;
Figs. 12 -16 are various views of the improved spring terminal of Fig. 7;
Fig. 17 is a cross-sectional view of an exemplary socket body and spring terminal assembled in contact with a PCB and LGA chip package;
Figs. 18a-c are various views of a spring terminal according to a second example not covered by the claimed invention;
Figs. 19a-c are various views of a spring terminal according to a third example not covered by the claimed invention;
Figs. 20a-c are various views of a spring terminal according to a fourth example not covered by the claimed invention;
Figs. 21a-c are various views of a spring terminal according to a fifth example not covered by the claimed invention;
Fig. 22 is a cross sectional view of an exemplary socket body and terminal with stop lugs according to another example not covered by the claimed invention;
Fig. 23 is a cross sectional view of an exemplary socket body and terminal according to an exemplary embodiment; and
Fig. 24 is a cross sectional view of an alternative exemplary socket body and terminal.

### Description of the Preferred Embodiments:

Certain exemplary embodiments will now be described to provide an overall understanding of the principles of the structure, function, manufacture, and use of the device and methods disclosed herein. One or more examples of these embodiments are illustrated in the accompanying drawings. Those skilled in the art will understand that the devices and methods specifically described herein and illustrated in the accompanying drawings are non-limiting exemplary embodiments and that the scope of the present invention is defined solely by the claims. The features illustrated or described in connection with one exemplary embodiment may be combined with the features of other embodiments. Such modifications and variations are intended to be included within the scope of the present disclosure provided that they fall within the scope of the appended claims. . Further, in the present disclosure, like-numbered components of the embodiments may have similar features, and thus within a particular embodiment each feature of each like-numbered component is not necessarily fully elaborated upon. Additionally, to the extent that linear or circular dimensions are used in the description of the disclosed systems, devices, and methods, such dimensions are not intended to limit the types of shapes that can be used in conjunction with such systems, devices, and methods. A person skilled in the art will recognize that an equivalent to such linear and circular dimensions can easily be determined for any geometric shape. Further, to the extent that directional terms like proximal, distal, top, bottom, up, or down are used, they are not intended to limit the systems, devices, and methods disclosed herein. A person skilled in the art will recognize that these terms are merely relative to the system and device being discussed and are not universal.

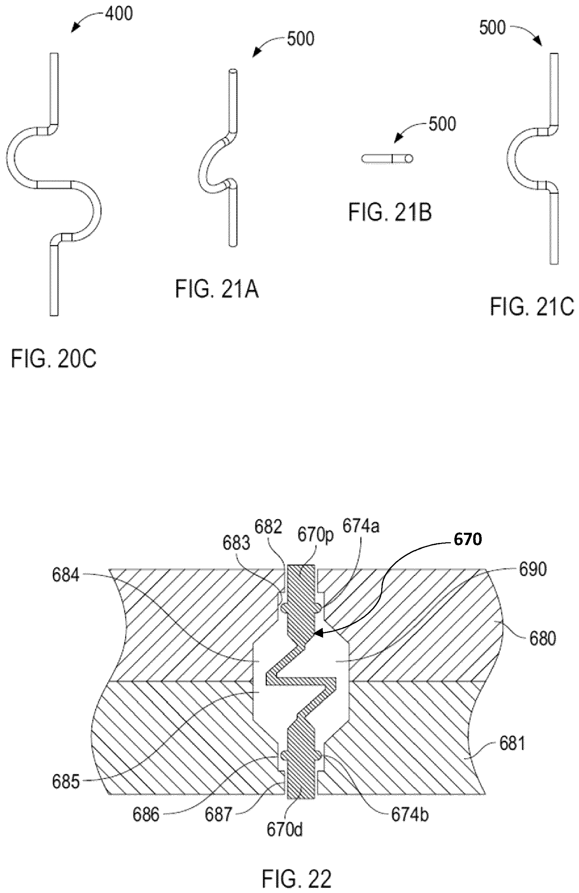

Referring now to the assembly shown in Figs. 7-17, said assembly not being covered by the claimed invention, the present disclosure provides an improved insulated socket body and spring terminal assembly 110 comprised of an insulated socket body generally indicated 112 and a plurality of individual spring terminals 170. For the sake of simplicity, Figs. 7-17 illustrate only the improved insulated socket body 112 and spring terminals 170 without the outer fixture and frame elements. However, it should be fully appreciated by one skilled in the art that the described socket body 112 and spring terminals 170 are configured to be received within the same or similar fixture 10 as described hereinabove. While only three terminals are shown, one of ordinary skill in the art would understand that these lumens and spring terminals would extend in an array as needed for the particular electrical device fixture. In general, the socket and terminal assembly 110 can be substantially similar to the socket assembly 10 shown in the prior art Fig. 6, for example. However, and importantly, the instant assembly 110 provides for an improved, reusable, and reliable electrical connection between the LGA chip 160 and the PCB 120. In some embodiments, the socket body 112 can be formed from an electrically insulating material, such as PVC, glass, asbestos, rigid laminate, varnish, resin, Teflon, rubber, etc. In the illustrated embodiment, as seen in Figs. 8-10 and 17, the socket body 112 can be formed from two mating parts, namely an upper socket body portion 180 and a lower socket body portion 181, which are the same or similar. The socket body 112 can receive one or a plurality of spring terminals or contact members 170a-c, disposed in an array, within corresponding lumens 190 that extend through the upper and lower socket body portions 180, 181 of the socket body 112. In some embodiments, the lumens 190 can generally have at least two different diameters, or cross-sectional dimensions. In some alternatives, the lumen can have at least three different diameters, as shown in Fig. 22.

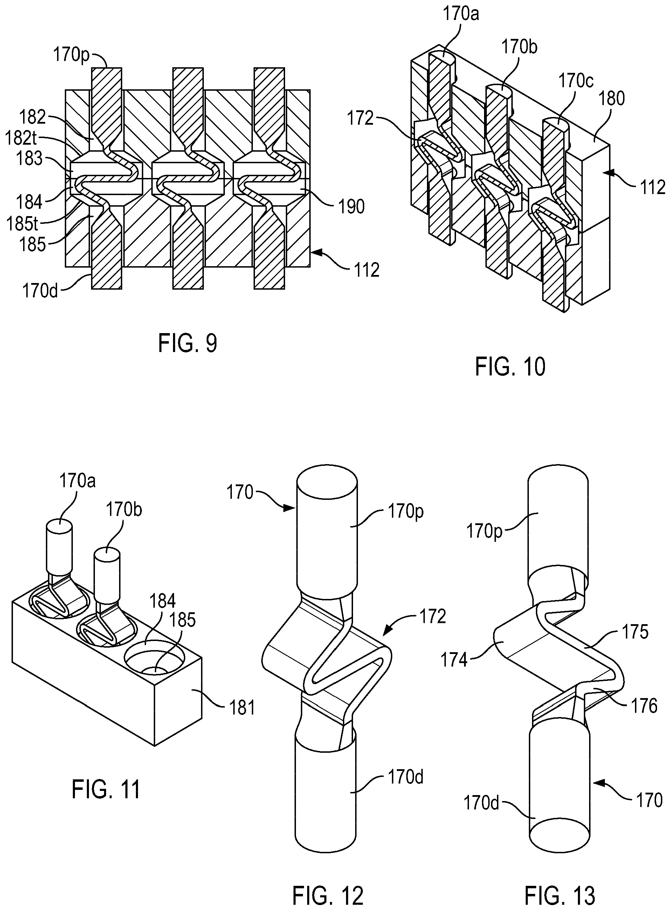

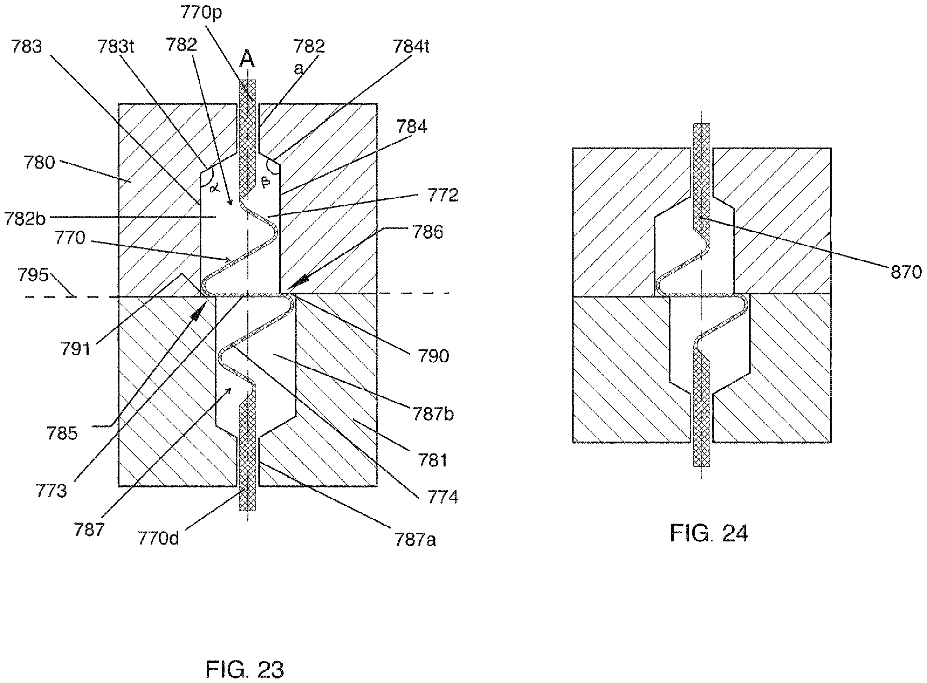

For example, as shown in Figs. 9-11, the lumens 190 can have a first upper guide opening section 182 in the upper body portion having a first diameter, a second spring recess section 183 having at least a second larger diameter. The transition region 182t from the first upper guide section 182 to the second spring recess section 183 can be gradual, as shown, or can be defined by a perpendicular shoulder portion such that there is no gradual increase of the interior diameter, or in a further alternative, a rounded shoulder can provide for a gradual increase/decrease of diameter. A coaxially aligned portion of the lumen 190 can be disposed in the lower body portion 181 and can substantially mirror the first and second sections 182, 183 of the upper body portion 180. As illustrated, a third upper spring recess section 184 can define a second half of the spring recess and have a diameter that is the same as the second diameter. Again, similar to the second section, the third section can have a transition section 185t that defines a gradual reduction in diameter to the fourth lower portion 185. Extending downward from the third upper section 184, the fourth lower section 185 can define a second, lower, guide opening. The fourth lower section 185 can have an interior diameter that is substantially equal to the first diameter of the first upper section 182 in the upper body portion 180. The lumen 190 can be symmetrical about the contact plane between the upper and lower body portion 180, 181 or can be asymmetrical as shown in Figs. 23 and 24. The upper and lower socket body portions 180, 181 can include a plurality of contact guide openings and spring recesses that, when mated together, form a plurality of axial guide passages and spring recesses for the respective terminals 170 received therein. The upper and lower socket body portions 180, 181 can be fixed together by known methods. The respective springs 170a-c disposed within the plurality of lumens 190 can be specially designed, as discussed below, to ensure proper contact between the LGA chip 160 and the PCB 120. Moreover, the respective springs 170a-c can be designed to be constrained within the socket body 110, no matter the orientation of the socket body itself, thereby reducing the possibility of the springs 170a-c being lost during transport, installation, or other handlings.

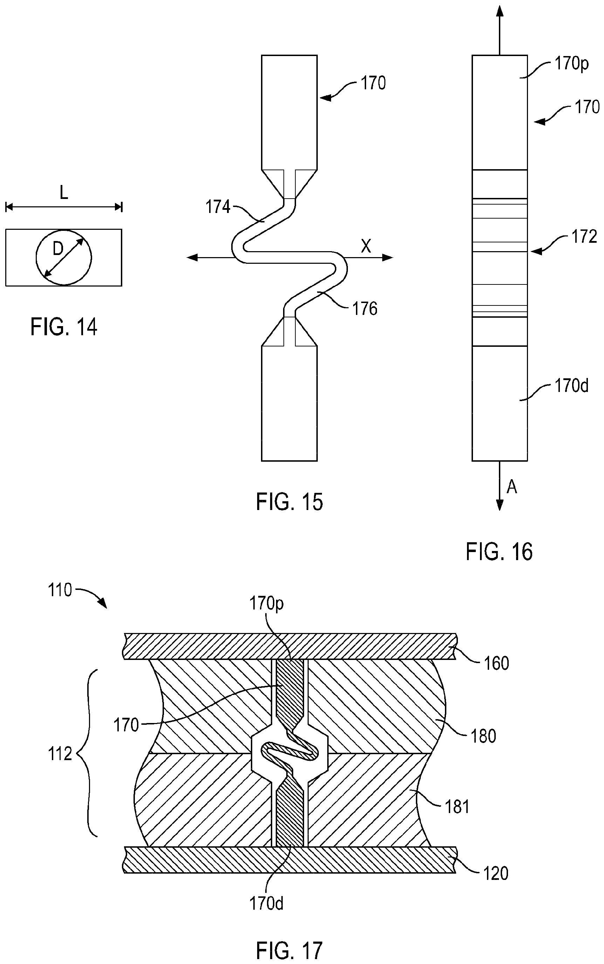

Referring to Figs. 12-16, the spring terminals 170a-c themselves can comprise a one-piece, monolithic, or unitary, structure that is stamped, forged, molded, rolled, or otherwise formed. The spring terminals 170 can be formed from any conductive metal which maintains an elastic spring bias in compression and can be formed from any cross-sectional shape such as round, rectangular, or square or a combination of stamped or formed shapes as illustrated. For the sake of simplicity, only a single spring terminal 170a will be discussed in detail, but it should be understood that all of the terminals 170 in this embodiment are substantially the same. In one embodiment, the upper and lower contact ends 170p, 170d can have a diameter D, or cross-sectional dimension, that is slightly less than the interior diameter of each of upper and lower guide portions 182, 185 of the lumens in the insulated socket body 112. Each spring terminal 170a can, in one embodiment have an upper terminal, or upper contact end 170p, a cantilever spring portion 172 extending downward from the upper contact end, and a lower terminal, or lower contact end 170d, that extends downward from the cantilever spring portion 172. In the illustrated embodiment, the central cantilever portion 172 can be defined as a central cantilever double V-spring. The two V-springs 174, 176 can, in some embodiments, be mirrored about an X axis and the compression axis A, as shown in Figs. 15 and 16, and share a central lever portion 175 that is disposed approximately in the center of the spring terminal 170a. The central cantilever portion 172 can have a generally rectangular cross-section. At least the central lever portion 175 can extend perpendicular to the terminal compression axis A which extends longitudinally through the upper and lower contact ends 170p, 170d, as shown in at least Figs. 15 and 16. One end of the central cantilever portion 175 can turn downwardly in a V-shape 176 and merge into the lower contact end (round cross-section) 170d, while the opposing end 174 can turn upwardly in a V-shape and merge into the upper contact end 170p (round cross-section), thereby forming two opposing V-springs 174, 176 that are mirrored as described above. A maximum cross-sectional dimension L of the central cantilever portion, in a direction that is perpendicular to the compression axis A, can be less than the maximum interior diameter of the spring recess 183, 184 to allow the spring terminal 170a to be compressed.

When received into the mated socket body portions 180, 181, the contact ends 170p, 170d are guided by the contact guide openings 182, 185, respectively, while the spring portion 172 is received into the spring recesses 183, 184 which provides space for compression of the spring 170a. Fig. 9 illustrates a first, at rest condition, of the terminals 170a-c within the guide body 112. In this condition, both contact ends 170p, 170d project from the contact body 180, 181, and it can be appreciated that the upper and lower contact ends 170p, 170d are both independently compressible into the socket body 112. Turning to Fig. 17, the socket body and terminal assembly 110 is mounted in compression between a PCB 120 and an LGA chip package 160. Compression of the central cantilever V-spring structure 172 along compression axis A to a second, compressed condition, can be seen and movement of the horizontal 175 and extension portions 174, 176 of the spring can be seen within the spring recesses 183, 184 , relative to the first condition of Fig. 9. The LGA frame and other structures are not shown for purposes of illustration and clarity of the inventive structures. Although not illustrated, it can be appreciated that when the socket assembly 110 is first mounted to the PCB, the lower contact ends 170d of the terminals 170 will engage and the spring portion 172 will be partially compressed, leaving the upper contact end 170p thereof still exposed and projecting from the socket body 112. Once the LGA chip package is seated and the frame closed, the upper contact end 170p will also be compressed into the configuration shown in Fig. 17.

The assembly thus features a novel spring terminal structures with opposing upper and lower contact ends which provides biased spring compression in both directions of contact and that provides independent movement of the upper and lower contact ends within a socket body.

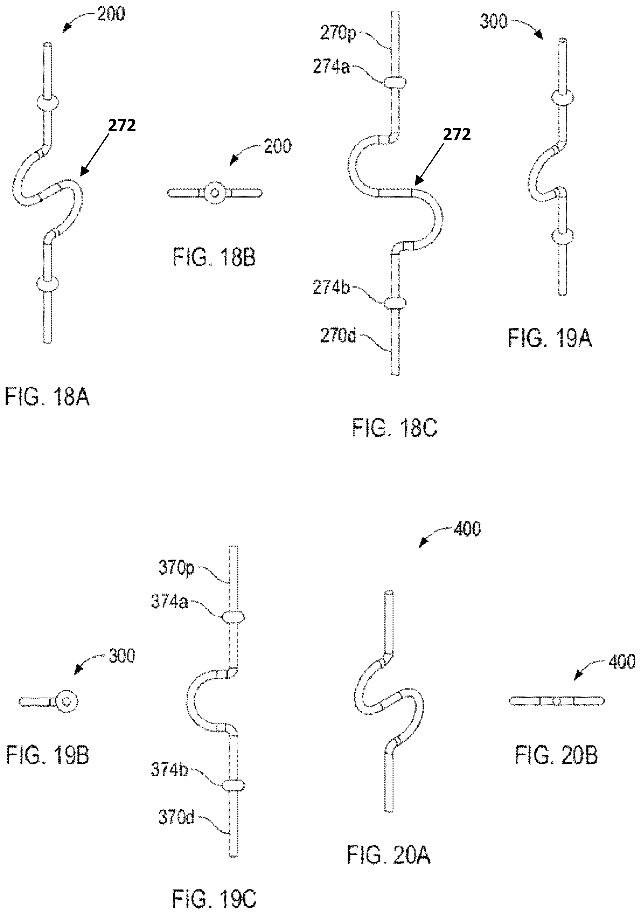

The instant disclosure contemplates alternative spring terminal constructions 200, 300, 400, 500. For the sake of simplicity, only the spring terminals will be discussed herein. Notably, in place of a spring terminal that provides for plural cross-sectional shapes, as shown in Figs. 7-17, the alternative spring terminals discussed all illustrate a single cross-sectional shape. Alternatively, these additional spring terminals can be manufactured such that they include a plurality of cross-sectional shapes. Figs. 18a-c illustrate an S-shape spring 272 form with a stop lug 274a, 274b formed on the upper and lower contact ends 270p, 270d. The S-shape spring 272 can be in the same location as the cantilever spring portion of the embodiment of Figs. 7-17 and can be formed by two mirrored C-shaped sections, like the two V-shaped springs 174, 176 of Fig. 7-17. The two stop lugs 274a, 274b can be used to limit the travel of the upper and lower contact ends along the compression axis. As shown in Fig. 22, with respect to a terminal spring 670, which is structurally like the terminal spring 170, two lugs 674a, 674b can be disposed on the upper and lower contact end 670p, 670d of the terminal spring 670. The lumen 690 of the insulated socket body can extend through the upper and lower portions 680, 681 and can be similar to the lumen 190, with the addition of an upper most section 682, which extends downward to an upper stop lug section or shoulder 683, which in turn extends downward to a spring retention section 684. The spring retention section 684 can align with a lower spring retention section 685, which extends downward to a lower step lug section or shoulder 686, which in turn extends to a lower most section 687. The spring retention section 684 and the lower spring retention section 685 can have a first diameter; the upper and lower stop lug sections 683, 686 can have a second diameter; and the upper most and lower most sections 682, 687 can have a third diameter. Where, the third diameter is smaller than the second diameter, and the second diameter is smaller than the first diameter. As the two stop lugs 674a, 674a abut the upper most and lower most sections 682, 687, respectively, they are prevented from overextending there through. Moreover, the stops can prevent the central spring portions from contacting the lumen when the test fixture is fixed to a printed circuit board and a portion of the contacts are compressed.

Alternatively, in place of the S shaped spring 200, as shown in Figs. 19a-c, a C shape spring 300 can be formed with a stop lugs 374a, 374b formed on the upper and lower contact ends 370p, 370d. In a further alternative, Figs. 20a-c illustrate an S shape spring form 400, like Figs. 19a-c, without the stop lug formed on the contact ends. Further still, Figs. 21a-c illustrate a C shape spring form 500 without the stop lug formed on the contact ends.

Referring to Fig. 23, a spring terminal 770 according to the invention is shown. In contrast to the prior examples not covered by the claimed invention, the embodiment of Fig. 23 differs in that the contact guide openings 782, 787 of the mated socket body portions 780, 781 can be mirrored in both the contact plane between the body portions 780, 781 and about the central axis A of the openings 782, 787. Additionally, the contact guide openings 782, 787 themselves are partially eccentric with respect to the central axis A such that a first side wall is disposed at a first distance from the axis A and a second side wall is disposed at a second distance from the axis A, such that the first and second distances are different. As the contact guide openings 782, 785 are merely mirrored with respect to the contact plane and the central axis, only the geometry of the guide opening 782 will be discussed for the sake of brevity.

The first, upper, opening 782 has a first upper guide opening section 782a in the upper body portion having a first diameter that is concentric with the central axis A. The opening 782 can extend downward towards a second spring recess section 782b defined by cross-sectional walls 783, 784, having at least a second larger diameter that is eccentric with both the central axis A and the first upper guide opening 782a. A first transition region 783t can extend from the first upper guide section 782a to a first lower wall section 783 which defines part of the second spring recess section 782b. The first transition region 783t can extend at a gradual first angle α, as shown, or can be defined by a perpendicular shoulder portion such that there is no gradual increase of the interior diameter, or in a further alternative, a rounded shoulder can provide for a gradual increase/decrease of diameter. The first lower wall section 783 can be disposed a first distance from the central axis. On the opposite side of the central axis A, a second transition region 784t can extend from the first upper guide section 782a to a second lower wall section 784 which can define part of the second spring recess section 782b. The second transition region 784t can extend at a gradual second angle β, as shown, or can be defined by a perpendicular shoulder portion such that there is no gradual increase of the interior diameter, or in a further alternative, a rounded shoulder can provide for a gradual increase/decrease of diameter. The second lower wall section 784 can be disposed a second distance from the central axis A. The first angle α and the second angle β, as shown in Fig. 23, are different such that the first and second lower wall sections, 783, 784 are of different lengths and disposed at different distances from the central axis A. The first and second lower wall sections 783, 784 can extend downward, towards the lower socket body portion 781 to the mating plane 795.

One advantage of the present embodiment of Fig. 23 is the eccentric design provides a stop 785 to be created in the first upper guide portion 782. The stop 785 is created at the intersection between the horizontal upper face 791 of the lower socket body portion 781 and the first lower wall section 783. Similarly, in the lower socket body portion 787b a second stop 786 is formed via the lower face 790 of the upper socket body portion 780 and a portion of the lower guide portion, unenumerated. The stops 785, 786 can be used to provide a fixed counter force point for a horizontal section 773 of the spring terminal 770 to provide for predictable loading of the spring terminal 770.

The upper and lower socket body portions 780, 781 can include a plurality of contact guide openings and spring recesses that, when mated together, form a plurality of axial guide passages and spring recesses for the respective terminals 770 received therein. The upper and lower socket body portions 780, 781 can be fixed together by known methods. In the fixed configuration, as shown in Fig. 23, the first upper guide opening 782a, the second lower guide opening 787a, and the central axis A are all concentric. In contrast, both of the first lower guide opening 782b and the second upper guide opening 787b are eccentric with each other, the first upper guide opening 782a, the second lower guide opening 787a, and the central axis A.

The terminal springs 770 disposed within the contact guide openings 782, 785 can be specially designed, as discussed below, to ensure proper contact between an LGA chip and a PCB (not shown). Moreover, the spring 770 can be designed to be constrained within the contact guide openings 782, 785, no matter the orientation of the socket body itself, thereby reducing the possibility of the springs 770 being lost during transport, installation, or other handlings.

The spring terminals 770 can be formed from any conductive metal which maintains an elastic spring bias in compression and can be formed from any cross-sectional shape such as round, rectangular, or square or a combination of stamped or formed shapes as illustrated. As shown in Fig. 23, the upper and lower contact ends 770p, 770d can have a diameter D, or cross-sectional dimension, that is slightly less than the interior diameter of each of upper and lower guide portions 782a, 787a. The spring terminal 770 can, in one embodiment have an upper terminal, or upper contact end 770p, a first "Z" shaped cantilever spring portion 772 extending downward from the upper contact end 770p, and a lower terminal, or lower contact end 770d, that extends downward from the second "Z" shaped cantilever spring portion 774. In the illustrated embodiment, the first "Z" shaped cantilever spring portion 772 and the second "Z" shaped cantilever spring portion 774 can share a central lever portion 773 that is disposed approximately in the center of the spring terminal 770. At least the central lever portion 773 extends perpendicular to the terminal compression axis, which extends longitudinally through the upper and lower contact ends 770p, 770d and can be the same and the central axis A. The first and second "Z" shaped cantilever spring portions 772, 774 and the central lever portion 773 can have a generally rectangular cross-section and the proximal and distal contact ends 770p, 770d can have a generally circular cross-section. The first and second "Z" shaped cantilever spring portions 772, 774 can, in some embodiments, be mirrored about an X axis and the central axis A. The first "Z" shaped cantilever spring portion 772 can be configured to be retained, in any configuration, within the first lower contact guide portion 782b and the proximal contact end 770p can be retained in the first upper contact guide portion 782a. Further, second "Z" shaped cantilever spring portion 774 can be configured to be retained, in any configuration, within the second upper contact guide portion 787b and the distal contact end 770d can be retained in the second lower contact guide portion 787a.

In an alternative embodiment, the spring terminal 870 can be substantially the same as the spring terminal 770 in the embodiment of Fig. 23, as shown in Fig. 24.

While the invention is illustrated herein in connection with a conventional LGA socket assembly and LGA chip package for semiconductors, it should be understood that LGA packages are manufactured and used in many other sizes and devices in many other industries. The presently disclosed contact body and terminal can be effectively utilized in any size LGA package and with varying LGA socket connectors and test sockets.

While there is shown and described herein certain specific structure embodying the invention, it will be manifest to those skilled in the art that various modifications and rearrangements of the parts may be made without departing from the scope of the invention, which is defined by the appended claims.

## Claims

1. An insulated socket body and terminal assembly comprising,
a spring terminal (770) including upper and lower contact ends (772,774) connected by a central spring (773);
an upper insulated socket body portion (780) having a contact guide opening (782) including a spring recess section (782b) and a guide opening section (782a); and
a lower insulated socket body portion (780) having a contact guide opening (787) including a spring recess section (787b) and a guide opening section (787a),
wherein the upper and lower insulated socket body portions are received together in mated relation along a mating plane (795) to define a socket body with a lumen extending therethrough,
wherein the spring terminal is received within the lumen with the central spring in the spring recess sections and the upper and lower contact ends in the respective upper and lower guide opening sections, said upper and lower contact ends projecting outwardly from respective upper and lower surfaces of the upper and lower insulated socket body portions,
said upper and lower guide opening sections (782a, 787a) having a first diameter that is concentric along a central compression axis (A), said central spring recess sections being configured to retain the central spring of the spring terminal in a first uncompressed configuration and in a second compressed configuration,
the assembly being **characterized in that**,
the central spring comprises a cantilever spring lever extending perpendicular to the central axis (A), and
the spring recess sections (782b, 787b) have a second larger diameter that is eccentric with respect to the central axis at the mating plane (795) such that there is first stop (785) created between an upper face (791) of the lower socket body portion (781) and a wall section (783) of the spring recess section (782b) and a second stop (786) created between a lower face (790) of the upper socket body portion (780) and a wall of the spring recess section (782b),
the stops (785, 786) providing a fixed counter force point for central spring (773).

2. The assembly of claim 1, wherein the central cantilever spring of the spring terminal is formed in the shape of a double Z shape, S shape, or double V shape.

3. The assembly of claim 1,
wherein the upper and lower contact ends of the spring terminal have a circular cross section, and
wherein the central cantilever spring has a rectangular cross section.

4. The assembly of claim 1, wherein the spring terminal has a circular cross section.

5. The assembly of claim 1,
wherein the central cantilever spring includes a first Z-shaped spring and a second Z-shaped spring, and
wherein the first Z-shaped spring and the second Z-shaped spring are mirrored about central axis (A).

6. The assembly of claim 1, wherein the at least one spring terminal is monolithic.

7. The assembly of claim 1, further comprising a plurality of lumens and a plurality of spring terminals.

## Patentansprüche

1. Isolierter Buchsenkörper und eine Anschlussbaugruppe, bestehend mit
- einem Federanschluss (770) mit einem oberen und einem unteren Kontaktende (772, 774), die durch eine zentrale Feder (773) verbunden sind;
- einem oberen isolierten Buchsenkörperabschnitt (780), der eine Kontaktführungsöffnung (782) mit einem Federaussparungsabschnitt (782b) und einem Führungsöffnungsabschnitt (782a) aufweist; und
- einem unteren isolierten Buchsenkörperabschnitt (780), der eine Kontaktführungsöffnung (787) mit einem Federaussparungsabschnitt (787b) und einem Führungsöffnungsabschnitt (787a) hat,
wobei der obere und der untere isolierte Buchsenkörperabschnitt in Anschlussbeziehung entlang einer Anschlussebene (795) zusammen aufgenommen werden, um einen Buchsenkörper mit einem Hohlraum zu definieren, der sich durch diesen hindurch erstreckt,
wobei der Federanschluss innerhalb des Hohlraumes mit der zentralen Feder in den Federaussparungsabschnitten und die oberen und unteren Kontaktenden in den jeweiligen oberen und unteren Führungsöffnungsabschnitten aufgenommen sind, wobei die oberen und unteren Kontaktenden von den jeweiligen oberen und unteren Oberflächen der oberen und unteren isolierten Buchsenkörperabschnitte nach außen ragen,
wobei die oberen und unteren Führungsöffnungsabschnitte (782a, 787a) einen ersten Durchmesser haben, der konzentrisch entlang einer Druckmittelachse (A) ist, wobei die zentralen Federaussparungsabschnitte gestaltet sind, um die zentrale Feder des Federanschlusses in einer ersten unkomprimierten Ausgestaltung und in einer zweiten komprimierten Ausgestaltung zu halten,
wobei die Baugruppe **dadurch gekennzeichnet ist,**
**dass** die zentrale Feder einen senkrecht zur Mittelachse (A) verlaufenden Auslegerfederhebelarm aufweist und
**dass** die Federaussparungsabschnitte (782b, 787b) einen zweiten größeren Durchmesser haben, der exzentrisch zur Mittelachse in der Anschlussebene (795) ist, so dass dort ein erster Anschlag (785), der zwischen einer oberen Fläche (791) des unteren Buchsenkörperabschnitts (781) und einem Wandabschnitt (783) des Federaussparungsabschnitts (782b) gebildet ist, und ein zweiter Anschlag (786) ist, der zwischen einer unteren Fläche (790) des oberen Buchsenkörperabschnitts (780) und einer Wand des Federaussparungsabschnitts (782b) gebildet ist,
wobei die Anschläge (785, 786) ein festes Widerlager für die zentrale Feder (773) bilden.

2. Baugruppe nach Anspruch 1,
wobei die zentrale Auslegerfeder des Federanschlusses in der Form einer Doppel-Z-Form, S-Form oder einer Doppel-V-Form ausgebildet ist.

3. Baugruppe nach Anspruch 1,
wobei die oberen und unteren Kontaktenden des Federanschlusses einen kreisförmigen Querschnitt aufweisen und
wobei die zentrale Auslegerfeder einen rechteckigen Querschnitt hat.

4. Baugruppe nach Anspruch 1,
wobei der Federanschluss einen kreisförmigen Querschnitt aufweist.

5. Baugruppe nach Anspruch 1,
wobei die zentrale Auslegerfeder eine erste Z-förmige Feder und eine zweite Z-förmige Feder aufweist und
wobei die erste Z-förmige Feder und die zweite Z-förmige Feder um eine Mittelachse (A) gespiegelt sind.

6. Baugruppe nach Anspruch 1,
wobei der mindestens eine Federanschluss einstückig ist.

7. Baugruppe nach Anspruch 1,
die weiterhin mehrere Hohlräume und mehrere Federanschlüsse aufweist.

## Revendications

1. Un corps de socket isolé et un ensemble de bornes comprenant,
une borne à ressort (770) comprenant des extrémités de contact supérieure et inférieure (772, 774) connectées par un ressort central (773) ;
une partie de corps de socket isolé supérieure (780) ayant une ouverture de guidage de contact (782) comprenant une section d'évidement de ressort (782b) et une section d'ouverture de guidage (782a) ; et
une partie de corps de socket isolé inférieure (780) ayant une ouverture de guidage de contact (787) comprenant une section d'évidement de ressort (787b) et une section d'ouverture de guidage (787a),
dans lequel les parties de corps de socket isolé supérieure et inférieure sont reçues ensemble dans une relation accouplée le long d'un plan d'accouplement (795) pour définir un corps de socket avec une lumière s'étendant à travers celui-ci,
dans lequel la borne à ressort est reçue à l'intérieur de la lumière avec le ressort central dans les sections d'évidement de ressort et les extrémités de contact supérieure et inférieure dans les sections d'ouverture de guidage supérieure et inférieure respectives, lesdites extrémités de contact supérieure et inférieure faisant saillie vers l'extérieur à partir des surfaces supérieure et inférieure respectives des parties de corps de socket isolé supérieure et inférieure,
lesdites sections d'ouverture de guidage supérieure et inférieure (782a, 787a) ayant un premier diamètre qui est concentrique le long d'un axe de compression central (A), lesdites sections d'évidement de ressort central étant configurées pour retenir le ressort central de la borne à ressort dans une première configuration non compressée et dans une deuxième configuration compressée,
l'ensemble étant **caractérisé en ce que**,
le ressort central comprend un levier à ressort en porte-à-faux s'étendant perpendiculairement à l'axe central (A), et
les sections d'évidement de ressort (782b, 787b) ont un deuxième diamètre supérieur qui est excentrique par rapport à l'axe central au niveau du plan d'accouplement (795) de sorte qu'il y a un premier arrêt (785) créé entre une face supérieure (791) de la partie de corps de socket inférieure (781) et une section de paroi (783) de la section d'évidement de ressort (782b) et un deuxième arrêt (786) créé entre une face inférieure (790) de la partie de corps de socket supérieure (780) et une paroi de la section d'évidement de ressort (782b),
les arrêts (785, 786) fournissant un point de contre-force fixe pour le ressort central (773).

2. Ensemble selon la revendication 1, dans lequel le ressort en porte-à-faux central de la borne à ressort est formé en forme de double Z, en forme de S ou en forme de double V.

3. Ensemble selon la revendication 1, dans lequel les extrémités de contact supérieure et inférieure de la borne à ressort ont une section transversale circulaire, et
dans lequel le ressort en porte-à-faux central a une section transversale rectangulaire.

4. Ensemble selon la revendication 1, dans lequel la borne à ressort a une section transversale circulaire.

5. Ensemble selon la revendication 1, dans lequel le ressort en porte-à-faux central comprend un premier ressort en forme de Z et un deuxième ressort en forme de Z, et
dans lequel le premier ressort en forme de Z et le deuxième ressort en forme de Z sont en miroir autour de l'axe central (A).

6. Ensemble selon la revendication 1, dans lequel l'au moins une borne à ressort est monolithique.

7. Ensemble selon la revendication 1, comprenant en outre une pluralité de lumières et une pluralité de bornes à ressort.
